# EUROPEAN PATENT SPECIFICATION

(11) **EP 3 471 523 B1**
(45) Date of publication and mention of the grant of the patent: **26.07.2023**
(21) Application number: 17195749.1
(22) Date of filing: 10.10.2017
(51) Int. Cl.: H05K 7/20

(54) **ECU COOLING ARRANGEMENT**
ESG-KÜHLANORDNUNG
AGENCEMENT DE REFROIDISSEMENT D'UNITÉ DE COMMANDE ÉLECTRONIQUE

(43) Date of publication of application: 17.04.2019
(73) Proprietor: Veoneer Sweden AB, 447 83 Vårgårda (SE)
(72) Inventor: Hökerek, Hakan, 82110 Germering (SE)
(74) Representative: Westpatent AB

(56) References cited:
- DE-A1-102016 106 180
- US-A1- 2002 186 532
- US-A1- 2005 196 904
- US-A1- 2005 279 109
- US-A1- 2011 135 520
- US-A1- 2015 195 952
- US-A1- 2015 369 545
- US-A1- 2016 345 469
- US-A1- 2017 205 858
- US-B1- 6 305 463
- US-B2- 7 307 840

## Description

The invention relates to an Electronic Control Unit (ECU) for controlling electronics in a vehicle, e.g. an ECU for control of safety devices.

In vehicles today, there is a lot of electronic equipment in order to provide for all the functionalities which are required for the essential functions of the vehicle such as engine control, monitoring and safety functions as well as for additional desired features, e.g. infotainment features. Many functions which earlier were provided by mechanical features have today been replaced by electronics and there has thus been an increased demand for more advanced control systems and Electronic Control Units (ECU). Hence, as the capacity and usage of the ECUs has increased over the years, also the heat generation in the ECU increases and overheating may be a problem. When the heat generated in the ECU is above a certain limit, a passive cooling will not be enough. If the ECU not may be cooled down to desired temperatures, the heat may cause irreparable effects in the ECU.

In US 9,591,786 is disclosed an electronic device including a Printed Circuit Board (PCB) and Central Processing Units (CPUs) or integrated circuits (IC) enclosed in a housing and thus forming an entity which could be interpreted to correspond to an Electronic Control Unit (ECU). The electronic device further includes a fan for actively forcing air though the housing via an inlet to an outlet in order to cool down the circuitry inside the housing of the electronic device. The device in US 9,591,786 will thus have an improved cooling compared to if there are no active cooling arrangements.

However, an active cooling as disclosed in US 9,591,786 will also cause an increased air flow and thus a possible increase in wear and tear of components inside the electronic device. In addition, if there are particles which adhere to the components will these particles contribute to heat insulation of the components and thus a decreased cooling effect. Hence, there is a need for a cooling system which ensures the Electronic Control Units (ECUs) comprised in the vehicle will be sufficiently cooled in order to last and avoid deterioration of the electronic equipment.

US 2011/135520 A1 relates to a fan motor controller housing includes an inner fan housing, an outer fan housing including a base plate, plenums and air passages, stator vanes and a motor control housing. The inner fan housing, the outer fan housing, the stator vanes, and the motor control component housing are all made of a polymer. The fan motor controller housing also includes heat sinks attached to the plenums. The heat sinks are cooled by air flowing from air passages through the plenum. Motor controller components are attached to the heat sink and heat dissipates from the motor controller components to the heat sink.

DE 10 2016 106180 A1 relates to a cooling device for cooling at least one electrical component of a vehicle, wherein a contact plate made of electrically insulating and thermally conductive material for flat contacting of the at least one electrical component and a closing element, which with the contact plate forms a cavity for guiding coolant, with at least one inlet opening for the supply of cool coolant into the cavity in the contact plate and/or in the closing element and at least one drain opening is formed for the discharge of heated coolant from the cavity.

US 2015/369545 A1 discloses a heat exchanger for cooling that is provided in contact with electronic components (heat exchange objects), such as semiconductors, that are arranged and mounted on an electronic control circuit board. Electronic components in US 2015/369545 are mainly cooled as a result of contact with an outer surface of the first molded body, or an outer surface of a second molded body. Further, this heat exchanger is basically constituted by the first molded body and the second molded body, which are two molded bodies. A space is created inside the heat exchanger by combining the two molded bodies in which the recesses have been molded, such that the inner surfaces face each other. In US 2015/369545 it is not disclosed a heat exchanger for cooling with an additional air cooling nor that at least one of the outer surfaces forms part of a housing for the electronic components.

In US 6,305,463 B1 it is disclosed electronic components including integrated circuits that are mounted to a clock printed circuit board assembly sandwiched between mounting plate and the board. Further, spacers project from board mounting surface to provide sufficient separation between mounting plate and the board assembly to provide clearance for the components. Moreover, in US 6,305,463 the mounting plate is preferably constructed from a material having high thermal conductivity. Further, a divider plate is positioned generally parallel to and sandwiched between mounting plate and cover for dividing cooling chamber into a liquid cooled section and an air cooled section. Divider plate is also preferably constructed from a relatively light weight, common and inexpensive material such as aluminum having significant heat transfer characteristics. Furthermore, in US 6,305,463 three internal cooling fin assemblies are positioned in liquid cooled section between mounting plate and divider plate for providing the heat exchanger characteristics of the liquid cooled section. And, a coolant fluid inlet and outlet communicate with liquid cooled section and are disposed in manifold. An external fin assembly is disposed in air cooled section between divider plate and cover for providing the heat exchanger characteristics of the air cooled section.

The electronic computer components in US 6,305,463 are neither described to be an Electronic Control Unit (ECU) nor are the electronic computer components in US 6,305,463 described to be for controlling electronics in vehicles.

The invention is thus directed to an Electronic Control Unit (ECU) designed to improve its cooling properties. The ECU comprises at least one Integral Circuit (IC) attached to a Printed Circuit Board (PCB), i.e. an ordinary ECU. The PCB usually comprises further electronics which also may be cooled using the arrangement described herein.

In order to improve the cooling of the ECU, and in particular the IC located on the PCB, is the ECU designed such that on top of the IC is located a first layer adjacent to the IC. This layer may for example be a sheet metal layer having a rather high thermal conductivity in order to promote heat dissipation from the IC. Above this first layer is a second layer located more distant from the IC. The first layer and second layer are spaced apart from each other such that a first void space is defined between the first layer and the second layer. This arrangement will thus allow a fluid to flow in the first void space and function as a cooling agent for removing heat transferred to the first layer from the IC.

The first layer serves two main purposes. A first purpose is to protect the IC from the surroundings, e.g. from direct contact with the cooling media and/or being polluted or contaminated by dust or dirt. The second purpose is to provide for a sufficient heat transfer. It is desired that the heat transfer through the first layer shall be as efficient as possible. A possible design choice for the first layer is a thin sheet of cupper. Also the second layer has high thermal conductivity even though the thermal conductivity in the second layer is less important sometimes.

Depending on the overall design of the ECU and its intended location and use, as well as the availability of liquid cooling media could the design of the first layer and the void space be different and adapted to the circumstances. For example, the first layer could be a sheet metal plate covering essentially the complete PCB and creating two separate compartments within the ECU, a first lower compartment comprising a PCB and an upper compartment forming the first void space for receiving a cooling media. Such an arrangement has the benefit of allowing a cooling media, liquid, to pass over a surface area covering the complete PCB while still avoiding the cooling media to come into direct contact with any of the components on the PCB. Note that only embodiment/s, as described herein, with a combined air and liquid cooling is/are part of the present invention. However, such a complete coverage and enclosing of the PCB may also inhibit cooling effects from natural convection.

The first layer could also be designed to cover each IC separately or a group of ICs such that there are separate pieces of the first layer for different ICs.

In order to assure a high thermal conductivity from the IC to a cooling media via the first layer could a layer of thermal paste be located between the first layer and the IC for improved thermal conduction between the first layer and the IC. The thermal paste will improve the thermal conductivity by filling out and replace void spaces which function as isolating spots and instead fill them up with a material having higher thermal conductivity.

The first layer and/or second layer should be made of a material having a high thermal conductivity, e.g. metal. The first layer and/or the second layer form part of the housing of the ECU. In general, these housings are made of sheet metal which is a suitable material.

As disclosed above, the first void space could be designed as one single space covering essentially the complete area of the ECU above the PCB. However, the first void space could also be a smaller space and the ECU could comprise a multitude of separate first void spaces. The single void space or several first void spaces may be fluidly connected to a fluid channel system. A first void space may be created for an individual IC, or for a group of ICs located close to each other, by providing the void space with side walls in the area on top of said IC or group of ICs. The side walls extends between said first layer and said second layer and define together with the first and second layer a compartment. The compartment has a compartment inlet and a compartment outlet connected to a fluid channel system. Hence, there may be a multitude of such compartments in the ECU interconnected by the fluid channel system and each compartment dedicated to cool a single IC or group of ICs.

Only embodiment/s, as described herein, with a combined air and liquid cooling is/are part of the present invention. In an example not according to the present invention, the ECU may be cooled by gas or liquid depending on the demand. In order to cool by the use of gas, the ECU may comprise a cooling fan for inducing a flow of gas, e.g. air, in the ECU. The gas is flowing from a housing inlet to a housing outlet via the first void space. There may of course be several housing inlets or outlets; in particular may it be beneficial to have several outlets in order to avoid stagnant zones, a phenomenon which in particular may occur if there are wide conduits or large compartments. This may for example be the case when the first void space covers essentially the complete area above the PCB. In an example not according to the present invention, there may be a fan located at one side of the ECU blowing air to one or several outlets at the other side. In order to control the flow within the first void space, there could be flow directors located inside the ECU. In an example not according to the present invention, there could be one or two fans located in the wall of the housing covering the upper side of the ECU and blowing air down towards the first layer and outlets could be provided at two or even all four sides in order to allow a flow all over the first layer in all possible directions.

The use of air as the circulating cooling media, in an example not according to the present invention, has the benefit of using a resource which always is present and available and even if there are some leaking in the system there will be no harm to the environment or lowered efficiency due to lack of cooling media. As long as the leakage is low and not essentially influences the cooling capacity the system may work very well. Hence, the advantage of using air is that the system may be designed in an easy way without the need to have leak-proof system or some kind of coolant reservoir. The use of air as the cooling media may function very well both when the void space is essentially one large empty compartment as well as when there are several void spaces connected to a fluid channel system.

The fluid channel system connected to the first void space may, in an example not according to the present invention, comprise a liquid phase media instead of gas. In general, when there is a desire for a more efficient cooling, it is desired to use a liquid phase media. A liquid cooling media has generally a considerably higher capability of absorbing heat per area unit from an area to be cooled, e.g. a compartment wall or a flange, than a gaseous media. Hence, the fluid channel system may be filled with a fluid coolant if there is a demand for a high capacity cooling system.

In an example not according to the present invention, the fluid channel system uses a liquid coolant may the fluid channel system be connected to a liquid source outside the ECU, e.g. be connected to an existing engine liquid cooling circuit in a vehicle. There may also be a separate cooling circuit for electronics which may include the ECU. The fluid channel system in the ECU may be connected to an outside source via a housing inlet provided with an inlet valve and a housing outlet provided with an outlet valve. Alternatively, there may be a single valve at either the inlet or the outlet which opens respectively cut off the through flow in the fluid channel system in the ECU. In either case, the fluid channel system may be designed such that the flow through the fluid channel system is completely provided for by the flow or pressure caused by the liquid source outside the ECU.

In an example not according to the present invention, the fluid channel system is designed for a liquid coolant could there be a pump in the ECU connected to the fluid channel system. The pump may thus be used for inducing a recirculating flow of cooling liquid in the ECU. In an example not according to the present invention, where the fluid channel system not is connected to another cooling system or having an inlet and outlet connected to a coolant flow it is necessary to provide the fluid channel system with a pump in the ECU in order to produce a desired coolant flow. However, a pump may be desired also in those cases when the fluid channel system is connected to a flowing coolant stream in order to better control the coolant flow within the ECU. It may also be possible that even if the fluid channel system in the ECU is connected to an outside source of coolant liquid could this arrangement be mainly used for refilling of liquid to the fluid channel system and the pump being used for recirculating the liquid in the fluid channel system.

The fluid channel system could also be designed to be connected to a liquid reservoir in the ECU. The reservoir may increase the functionality of the cooling system in particular if the fluid channel system not is connected to an outside source or when the through-flow from an outer source is shut off. However, only embodiment/s, as described herein, with a combined air and liquid cooling is/are part of the present invention. The reservoir could be provided with a reservoir fan for inducing an air flow for cooling of the liquid in the liquid reservoir. Hence, in this case is there an active cooling using both air and a liquid coolant for reducing the temperature in the ECU. The use of both air and liquid cooling is particularly suitable to be used when the ECU is designed with a third layer located on top of the second layer defining a second void space between the second layer and the third layer. In this case could for example the first and second layer be made of a thin sheet material having high thermal conductivity, e.g. cupper, inside the ECU while the third layer could be the upper side of the ECU housing. This arrangement may thus be arranged to include a liquid cooling in the first void space, e.g. a fluid channel system designed to be filled up with a liquid coolant, and a gas, e.g. air, cooling arrangement in the second void space between the second layer and the third layer.

The air cooling is made by providing an induced flow of air in the second void space. This may be made by either using one or several fans directing a flow of air into a large open compartment or using a fluid channel system for directing the air flow to desired spots or sub compartments in the second void space.

In one specific embodiment of the invention could the above arrangement with liquid cooling in the first void space and air cooling in the second void space be arranged to also include the liquid reservoir which has been described above. It may for example be possible to have a reservoir fan for introducing air to the ECU through its upper side and directed towards a heat exchange area thermally connected to the liquid reservoir, e.g. a thin metal sheet dividing the ECU into the first void space and second void space while being used as the second layer and also function as a wall for the liquid reservoir. If desired, there could also be lamellas which are thermally connected to the liquid reservoir and located in the air stream from the fan such that there is an increased heat reduction in the liquid reservoir from an increased heat transfer from the reservoir to the cooling air.

The air from the reservoir fan, used primarily for cooling of the liquid in the liquid reservoir, may thereafter be guided in the second void space (between the second layer and the third layer) to an air outlet in such a way that the air may be used to further cool down the interior of the ECU.

It has been described above that the reservoir fan may be designed to include lamellas in close vicinity to the fan and thermally connected to the liquid reservoir. A similar arrangement may be used for other fans as well which purpose is to create a cooling air flow in the ECU. Any fan arrangement could be designed to include lamellas downstream of, and possibly also in close vicinity to, the fan. The lamellas should be thermally connected to the subject to be cooled such that the lamellas function as cooling flanges. In addition, any object which is intended to be cooled, e.g. an IC, may be provided with lamellas connected to or forming part of the first layer so as to function as cooling flanges for the object, e.g. an IC, to be cooled.

### BRIEF DESCRIPTION OF FIGURES

FIGURES 1 a-b discloses an ECU according to prior art wherein figure 1a discloses an isometric view and figure 1b discloses a cross sectional side view
FIGURES 2 a-f disclose different examples, not according to the present invention, of an ECU comprising a cooling system according to the invention;
Figure 2a discloses an example, not according to the present invention, being a cross sectional side view of the ECU,
Figure 2b discloses an example, not according to the present invention, being a top view of an air guiding system for air being used as cooling medium,
Figures 2c-2e discloses different examples, not according to the present invention, being cross sectional structures of the cooling arrangement, and
Figure 2f discloses an example, not according to the present invention, being a top view of a fluid channel system for a liquid coolant being used as cooling media
FIGURES 3 a-d discloses a cooling system having combined air and liquid cooling;
Figure 3a discloses a view from above of a liquid cooling system combined with an air cooling system,
Figures 3b-3d discloses cross sectional views of different parts of the cooling system disclosed in figure 3a.

### DETAILED DESCRIPTION OF THE FIGURES

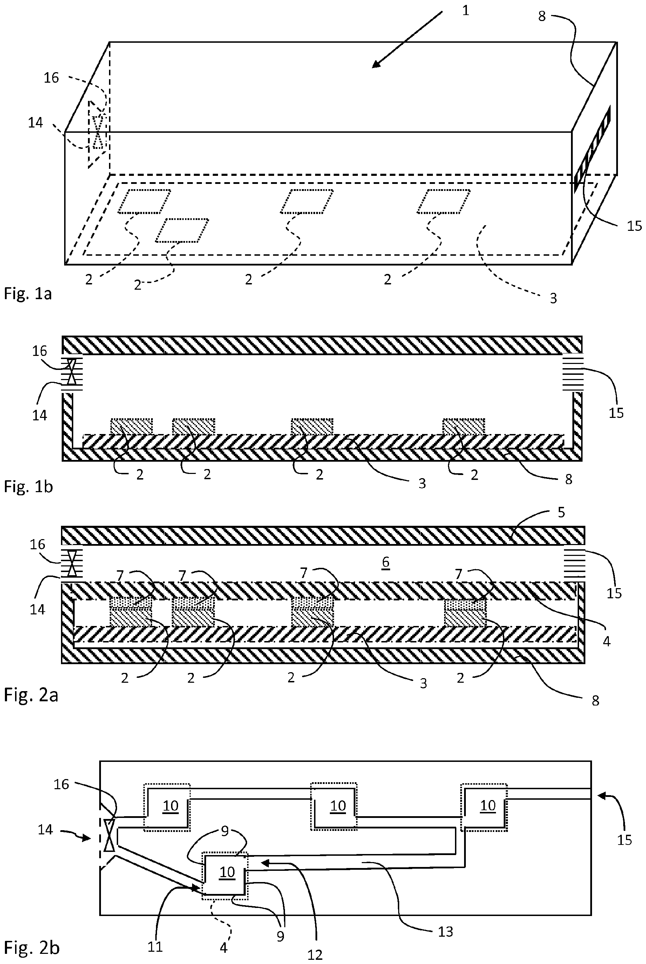

Figures 1a and 1b disclose an Electronic Control Unit (ECU) 1. In figure 1a is disclosed an isometric view and in figure 1b is the same ECU disclosed showing a cross sectional side view. The ECU comprises a Printed Circuit Board (PCB) 3 provided with several Integrated Circuits (ICs) 2. The housing 8 of the ECU is also provided with a housing inlet 14 and a housing outlet 15 in order to enable a flow of ventilation air and increase heat dissipation from the ECU. The inlet 14 and outlet 15 may be used for creating an air flow by natural convection or alternatively use a fan 16 in order to provide an active cooling.

However, even though the arrangement in figure 1 provide for cooling of the ECU 1, and even an active cooling by including a fan 16, may the arrangement be improved and designed to provide a desired cooling while also protecting the electronic circuitry inside the housing 8 from the environment. The arrangement in figure 1 provides an air flow for cooling of the PCB 3 and its associated ICs 2 but do not provide a safe environment for the subjects to be cooled, e.g. the PCB 3 and ICs 2, why the arrangement in figure 1 not is suitable for a long lasting, efficient cooling of the ECU 1.

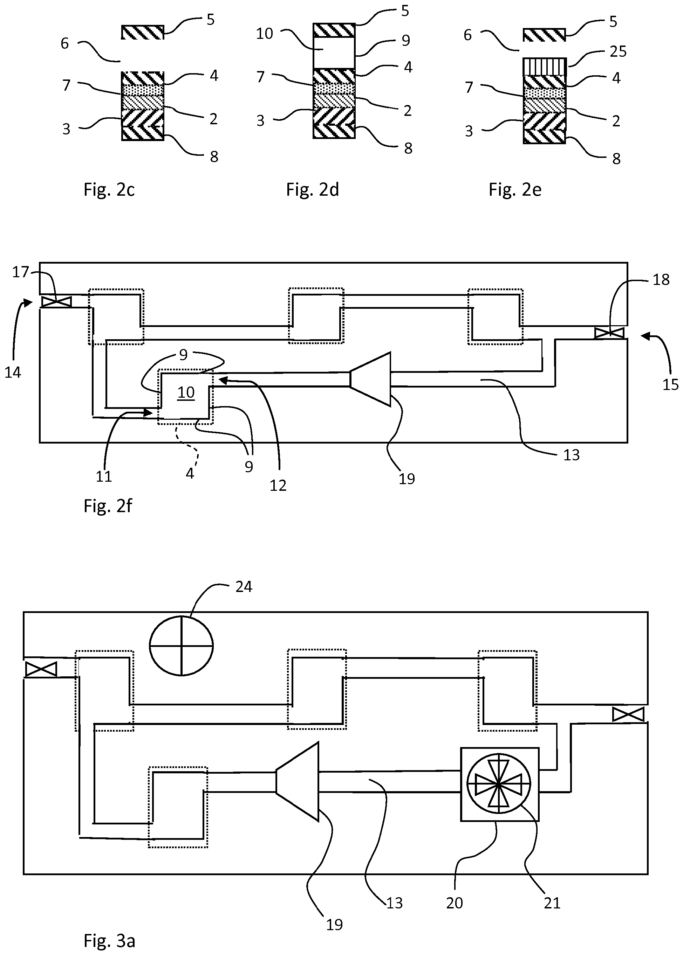

In figure 2a is disclosed an example, not according to the present invention, being a cooling arrangement for an ECU 1 according to an embodiment of the invention. The ECU 1 in figure 2 differs from the one described in figure 1 in that a first layer 4, e.g. a metal sheet, has been inserted into the housing 8 of the ECU 1 and thus divides the ECU 1 in a lower compartment comprising the PCB 3 and the ICs 2 attached onto the PCB 3 and an upper compartment, also referred to as a first void space 6, which is formed between the first layer 4 and the second layer 5, which in this case is formed by the upper side of the housing 8. Hence, the air to be used for ventilation and cooling of the ECU will be forced to flow in the first void space 6 by the fan 16. The ventilation air will thus not come into direct contact with the PCB 3 or ICs 2 but will provide a cooling of the ICs 2 by a heat transfer via the first layer 4. In order to ensure that the heat transfer from the IC 2 to the ventilation air in the first void space 6 will be efficient is it important that the heat conductivity there between is efficient. Reliable heat conductivity may be achieved by using a thermal paste 7 which thus function as a heat conductor between the IC 2 and the first layer 4 such that the heat may dissipate from the IC 2 and be transferred to the ventilation air.

The void space 6 between the first layer 4 and second layer 5 may be just an empty space. The space could include some air guide means if desired in order to avoid hotspots and/or to somewhat direct the air towards locations where it is expected that there will be a rather high generation of heat. It shall also be noted that even though the disclosure is exemplified for having gas (air) as cooling media, it could be replaced for a liquid without the need to perform any major modifications. However, if a liquid should be used, the need for providing a completely leak-proof design is increased and there is also a need to provide a liquid source.

In figure 2b an example, not according to the present invention, being is disclosed an example of how a fluid channel system 13 may be designed to be fitted into the first void space 6 (se figure 2a) in order to provide a more controlled ventilation system of the ECU 1 than what was disclosed in figure 2a. This fluid channel system 13 is primarily intended to exemplify how it may be used for a gaseous media, e.g. air, to be used in the fluid channel system. The fluid channel system 13 connects compartments 10 built up on top of the ICs 2 (see figure 1 and 2a). The compartments 10 are made by side walls 9 extending between the first layer 4 and the second layer 5 (not shown, see figure 2a or 2c) thus defining a confined first void space 6. The compartments 10 are provided with a compartment inlet 11 and a compartment outlet 12 in order to provide a through flow of cooling media in the compartments 10. The fluid channel system 13 is very basic and could include further features, e.g. valves and further piping in order to better control the flow depending on the present desire. The system could also be provided with sensors for automatic control of the coolant flow in the system, e.g. temperatures sensors, flow rate sensors, etc.

In figure 2c-2e are disclosed examples, not according to the present invention, being a couple of different cross sectional views of the interior of the ECU 1 as disclosed in figures 2a and 2b. In all figures 2c to 2e are disclosed the bottom of the housing 8 serving as the base upon which the PCB 3 is resting. On top of the PCB is an IC 2 positioned which via a thermal paste 7 is connected to a first layer, e.g. a metal sheet, which is located apart from a second layer 5, which in this case is the upper side of the housing of the ECU, such that a void space 6 is formed between the first and second layers 4, 5.

In figure 2c, being an example, not according to the present invention, the features disclosed above are all features present and this schematic view could for example be the cross section of the ECU disclosed in figure 2a in which the first void space 6 is exemplified as a large, empty compartment.

In figure 2d, being an example, not according to the present invention, is disclosed still further features which are side walls 9 which are used to create the small, confined compartments 10 which are created above each IC 2 as disclosed in figure 2b. Figure 2d thus represents a cross sectional view from the bottom of the casing 8 to the upper side of the casing being the second layer 5 in the area where an IC 2 is located in figure 2b.

In figure 2e, being an example, not according to the present invention, is disclosed an additional feature, lamellas 25, which are attached to the first layer 4 and located in the void space 6. The lamellas could be added to either embodiment disclosed in figure 2c or 2d. The lamellas will function as flanges for increased heat exchange between the first layer 4 and a cooling media present in the void space 6, i.e. normally increased cooling of the first layer and a thermally connected IC 2.

In figure 2f, being an example, not according to the present invention, is disclosed still an example of how a fluid channel system 13 may be designed to be fitted into the first void space 6 (se figure 2a) if a liquid is desired to be used in the fluid channel system 13. The main layout is similar to the one described in figure 2b and the fluid channel system 13 described therein. Also in figure 2f are there compartments 10 which are built up on top of the ICs 2 (not shown, see fig 1) by side walls 9 stretching from the first layer 4 to the second layer 5 (se fig 2b). The compartments 10 are provided with a compartment inlet 11 and a compartment outlet 12 made by holes in the side walls 9 and thereby connected to the fluid channel system 13.The main differences in the schematic layout of the cooling system in figure 2f compared to the system in figure 2b (suitable for a gas cooling media) is that there is a pump 19 present instead of a fan and the housing inlet 14 and housing outlet 15 have been provided with an inlet valve 17 respectively an outlet valve 18. The valves will thus make it possible to control the amount of cooling liquid entering and leaving the system and the pump may be used to recirculate the cooling liquid within the ECU.

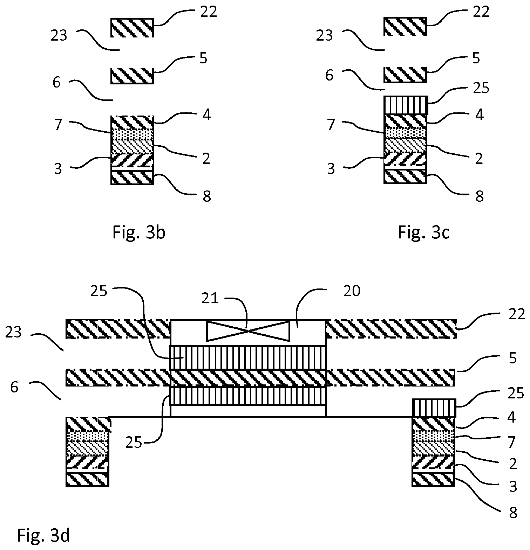

In figure 3a is disclosed a schematic overview of a cooling system using both air cooling and liquid coolant. In this embodiment is it intended to have a liquid cooling system, e.g. such a system as disclosed in figure 2f, in the first void space 6 (see figure 2a). Since all the features which are disclosed in figure 2f describing such a system also are disclosed in figure 3a will most of these features already explained in figure 2f not be addressed in this figure. However, the system has been modified by adding the feature of a liquid reservoir 20, which is used for storage of the liquid coolant to be used in the fluid channel system 13 in the first void space 6 and a reservoir fan 21 for providing an airflow in a second void space 23 created between a third layer 22 and the second layer 22(see figure 3d). The flow from the reservoir fan 21 will be guided from the inlet close to the fan 21 to an air outlet 24 in the upper wall of the housing 8. The air flow could either be directed through an essentially empty second void space 23, e.g. an empty space reminding of the one disclosed for the first void space in figure 2a, or through a fluid channel system 13 for air as disclosed in figure 2b.

In figures 3b to 3d are disclosed cross sectional views of the system in figure 3a in different areas. In figure 3b is disclosed the bottom of the housing 8 serving as the base upon which the PCB 3 and an IC 2 are positioned. The IC 2 is provided with the thermal paste 7 to be thermally conductive to the first layer 4 being separated from the second layer 5 by the first void space 6. The second void space 23 is located between the second layer 5 and the third layer 22. This cross sectional view thus corresponds to an area below and above an IC 2.

Also figure 3c corresponds to an area below and above an IC 2. However, in figure 3c is the cross sectional view from the area of the IC 2 disclosing an IC 2 which has been provided with lamellas 25 extending from the first layer 4 into the first void space 6. The lamellas 25 function as heat dissipating flanges.

In figure 3d is disclosed a cross sectional view of the ICs from figures 3b and 3c as well as a cross sectional view of a liquid reservoir 20 provided with a fan 21. The fan 21 will create a flow of air with in the second void space 23. Close to the reservoir fan 21 and the inlet to the second void space 23 are flanges 25 located in order to be cooled by the air admitted to the second void space. The flanges 25 in the air stream will dissipate air from the liquid since they are thermally connected to the cooling liquid via the second layer 5. The second layer 5 is connected with further flanges 25 which are immersed into the cooling liquid and thus improve heat transfer from the cooling liquid to the second layer 5. Hence, as the cooling liquid is recirculated in the first void space 6 will it be heated as it passes by hot areas, e.g. areas above of ICs 2, and thereafter cooled when returning to the reservoir 20.

## Claims

1. An Electronic Control Unit (ECU) (1) for controlling electronics in a vehicle comprising at least one Integrated Circuit (IC) (2) attached to a Printed Circuit Board (PCB) (3) on top of said IC (2) is located a first layer (4) adjacent to the IC (2) and a second layer (5) more distant from the IC (2), wherein said first layer (4) and said second layer (5) are made of a material having a high thermal conductivity, e.g. metal, and at least one of said first layer (4) and second layer (5) forms part of a housing (8) of the ECU (1) wherein said first layer (4) and second layer (5) are spaced apart from each other such that a first void space (6) is defined between the first layer (4) and the second layer (5) allowing a fluid to flow in the first void space (6) wherein said first void space (6) is also provided with side walls (9) in the area on top of said IC (2) and together with said first layer (4) and said second layer (5) define a compartment (10) built up on top of the IC (2), the compartment (10) being made by the side walls (9) extending between said first layer (4) and said second layer (5), the compartment (10) having a compartment inlet (11) and compartment outlet (12) connected to a fluid channel system (13) in said first void space (6) in the ECU (1) comprising a liquid phase media, said ECU (1) further comprising a third layer (22) located on top of the second layer (5) defining a second void space (23), between the second layer (5) and the third layer (22), in which a flow of air is induced.

2. An ECU (1) according to claim 1 wherein a layer of thermal paste (7) is located between the first layer (4) and the IC (2) in order to thermally connect the first layer (4) with the IC (2).

3. An ECU (1) according to claim 1 wherein the fluid channel system (13) is connected to a liquid source via a housing inlet (14) provided with an inlet valve (17) and a housing outlet (15) provided with an outlet valve (18).

4. An ECU (1) according to claim 1 or 3 wherein there is a pump (19) in the ECU (1) connected to the fluid channel system (13) for inducing a re-circulating flow of cooling liquid in the ECU (1).

5. An ECU (1) according to any of claims 1, 3 or 4 wherein the fluid channel system (13) comprises a liquid reservoir (20) which is provided with a reservoir fan (21) for inducing an air flow for cooling of the liquid in the liquid reservoir (20), and wherein the air from the reservoir fan (21) is guided through the second void space (23) between the second layer (5) and the third layer (22) to an air outlet (24).

6. An ECU (1) according to any previous claim wherein a fan (21) for creating a cooling air flow in the ECU (1) is designed to include lamellas (25), downstream of and in close vicinity to the fan (21), and being thermally connected to the subject to be cooled, wherein the subject to be cooled is the liquid in the liquid reservoir (20), such that the lamellas (25) function as cooling flanges.

7. An ECU (1) according to any previous claim wherein the IC (2) is provided with lamellas (25) connected to or forming part of the first layer (4) so as to function as cooling flanges for the IC (2).

## Patentansprüche

1. Elektronisches Steuergerät (1) zum Steuern der Elektronik in einem Fahrzeug, umfassend wenigstens eine integrierte Schaltung (2), die an einer Leiterplatte (3) angebracht ist, wobei sich auf der integrierten Schaltung (2) eine erste Schicht (4) angrenzend an die integrierte Schaltung (2) befindet und sich eine zweite Schicht (5) weiter entfernt von der integrierten Schaltung (2) befindet, wobei die erste Schicht (4) und die zweite Schicht (5) aus einem Material hergestellt sind, das eine hohe Wärmeleitfähigkeit aufweist, z.B. Metall, und die erste Schicht (4) und/oder die zweite Schicht (5) Teil eines Gehäuses (8) des elektronischen Steuergeräts (1) bildet, wobei die erste Schicht (4) und die zweite Schicht (5) auf eine solche Weise voneinander beabstandet sind, dass ein erster Hohlraum (6) zwischen der ersten Schicht (4) und der zweiten Schicht (5) definiert ist, der es ermöglicht, dass eine Flüssigkeit in dem ersten Hohlraum (6) fließt, wobei der erste Hohlraum (6) außerdem im Bereich auf der integrierten Schaltung (2) mit Seitenwänden (9) versehen ist, die zusammen mit der ersten Schicht (4) und der zweiten Schicht (5) eine Kammer (10) definieren, die auf der integrierten Schaltung (2) aufgebaut ist, wobei die Kammer (10) dadurch gebildet ist, dass sich die Seitenwände (9) zwischen der ersten Schicht (4) und der zweiten Schicht (5) erstrecken, wobei die Kammer (10) einen Kammereinlass (11) und einen Kammerauslass (12) aufweist, die in dem ersten Hohlraum (6) in dem elektronischen Steuergerät (1) mit einem Fluidkanalsystem (13) verbunden sind, das ein Flüssigphasenmedium umfasst, wobei das elektronische Steuergerät (1) ferner eine dritte Schicht (22) umfasst, die sich auf der zweiten Schicht (5) befindet und einen zweiten Hohlraum (23) zwischen der zweiten Schicht (5) und der dritten Schicht (22) definiert, in der ein Luftstrom bewirkt wird.

2. Elektronisches Steuergerät (1) nach Anspruch 1, wobei sich zwischen der ersten Schicht (4) und der integrierten Schaltung (2) eine Schicht aus einer Wärmeleitpaste (7) befindet, um die erste Schicht (4) thermisch mit der integrierten Schaltung (2) zu verbinden.

3. Elektronisches Steuergerät (1) nach Anspruch 1, wobei das Fluidkanalsystem (13) über einen Gehäuseeinlass (14), der mit einem Einlassventil (17) versehen ist, und einem Gehäuseauslass (15), der mit einem Auslassventil (18) versehen ist, mit einer Flüssigkeitsquelle verbunden ist.

4. Elektronisches Steuergerät (1) nach Anspruch 1 oder 3, wobei sich in dem elektronischen Steuergerät (1) eine Pumpe (19) befindet, die zum Bewirken eines rezirkulierenden Kühlflüssigkeitsstroms in dem elektronischen Steuergerät (1) mit dem Fluidkanalsystem (13) verbunden ist.

5. Elektronisches Steuergerät (1) nach Anspruch 1, 3 oder 4, wobei das Fluidkanalsystem (13) einen Flüssigkeitsbehälter (20) umfasst, der mit einem Behälterlüfter (21) zum Bewirken eines Luftstroms zum Kühlen der Flüssigkeit in dem Flüssigkeitsbehälter (20) versehen ist, und wobei die von dem Behälterlüfter (21) kommende Luft durch den zweiten Hohlraum (23) zwischen der zweiten Schicht (5) und der dritten Schicht (22) zu einem Luftauslass (24) geleitet wird.

6. Elektronisches Steuergerät (1) nach einem der vorhergehenden Ansprüche, wobei ein Lüfter (21) zum Erzeugen eines Kühlluftstroms in dem elektronischen Steuergerät (1) dazu ausgelegt ist, stromabwärts von dem Lüfter (21) und in unmittelbarer Nähe zu diesem Lamellen (25), die thermisch mit dem zu kühlenden Gegenstand verbunden sind, zu umfassen, wobei es sich bei dem zu kühlenden Gegenstand um die Flüssigkeit in dem Flüssigkeitsbehälter (20) handelt, und zwar auf eine solche Weise, dass die Lamellen (25) als Kühlflansche wirken.

7. Elektronisches Steuergerät (1) nach einem der vorhergehenden Ansprüche, wobei die integrierte Schaltung (2) mit Lamellen (25) versehen ist, die mit der ersten Schicht (4) verbunden sind oder Teil derselben bilden, um als Kühlflansche für die integrierte Schaltung (2) zu wirken.

## Revendications

1. Bloc de commande électronique (1) servant à commander des composants électroniques dans un véhicule, comprenant au moins un circuit intégré (2) attaché à une carte de circuit imprimé (3), une première couche (4) adjacente au circuit intégré (2) et une deuxième couche (5) plus éloignée du circuit intégré (2) étant situées au-dessus dudit circuit intégré (2), ladite première couche (4) et ladite deuxième couche (5) étant faites d'un matériau présentant une haute conductivité thermique, par ex. du métal, et au moins l'une de ladite première couche (4) et ladite deuxième couche (5) faisant partie d'un boîtier (8) du bloc de commande électronique (1), ladite première couche (4) et ladite deuxième couche (5) étant espacées l'une de l'autre de telle sorte qu'un premier espace vide (6) est défini entre la première couche (4) et la deuxième couche (5) permettant à un fluide de s'écouler dans le premier espace vide (6), ledit premier espace vide (6) étant également pourvu de parois latérales (9) dans la région au-dessus dudit circuit intégré (2) définissant, conjointement avec ladite première couche (4) et ladite deuxième couche (5), un compartiment (10) formé au-dessus du circuit intégré (2), le compartiment (10) étant constitué par les parois latérales (9) s'étendant entre ladite première couche (4) et ladite deuxième couche (5), le compartiment (10) comportant une entrée de compartiment (11) et une sortie de compartiment (12) raccordées à un système de canaux à fluide (13) dans ledit premier espace vide (6) dans le bloc de commande électronique (1) comprenant une substance en phase liquide, ledit bloc de commande électronique (1) comprenant, en outre, une troisième couche (22) située au-dessus de la deuxième couche (5) définissant un second espace vide (23), entre la deuxième couche (5) et la troisième couche (22), dans lequel est généré un écoulement d'air.

2. Bloc de commande électronique (1) selon la revendication 1, dans lequel une couche de pâte thermique (7) est située entre la première couche (4) et le circuit intégré (2) afin de raccorder thermiquement la première couche (4) au circuit intégré (2).

3. Bloc de commande électronique (1) selon la revendication 1, dans lequel le système de canaux à fluide (13) est raccordé à une source de liquide par le biais d'une entrée de boîtier (14) pourvue d'une vanne d'entrée (17) et d'une sortie de boîtier (15) pourvue d'une vanne de sortie (18).

4. Bloc de commande électronique (1) selon la revendication 1 ou 3, dans lequel une pompe (19) est située dans le bloc de commande électronique (1), celle-ci étant raccordée au système de canaux à fluide (13) pour générer un écoulement recyclé de liquide de refroidissement dans le bloc de commande électronique (1) .

5. Bloc de commande électronique (1) selon l'une quelconque des revendications 1, 3 et 4, dans lequel le système de canaux à fluide (13) comprend un réservoir de liquide (20) qui est pourvu d'un ventilateur de réservoir (21) pour générer un écoulement d'air afin de refroidir le liquide dans le réservoir de liquide (20), et dans lequel l'air venant du ventilateur de réservoir (21) est guidé à travers le second espace vide (23) entre la deuxième couche (5) et la troisième couche (22) jusqu'à une sortie d'air (24).

6. Bloc de commande électronique (1) selon l'une quelconque des revendications précédentes, dans lequel un ventilateur (21) servant à créer un écoulement d'air de refroidissement dans le bloc de commande électronique (1) est conçu pour comprendre des lamelles (25), en aval et à proximité immédiate du ventilateur (21), et étant raccordées thermiquement au sujet à refroidir, le sujet à refroidir étant le liquide dans le réservoir de liquide (20), de telle sorte que les lamelles (25) fonctionnent comme des ailettes de refroidissement.

7. Bloc de commande électronique (1) selon l'une quelconque des revendications précédentes, dans lequel le circuit intégré (2) est pourvu de lamelles (25) raccordées à la première couche (4) ou faisant partie de celle-ci de façon à fonctionner comme des ailettes de refroidissement pour le circuit intégré (2).
